# EUROPÄISCHE PATENTANMELDUNG

(11) **EP 0 883 071 A1**
(43) Veröffentlichungstag der Anmeldung: **09.12.1998**
(21) Anmeldenummer: 98109249.7
(22) Anmeldetag: 20.05.1998
(51) Int. Cl.: G06F 17/50

(54) **Verfahren zur Optimierung von Signallaufzeiten in einem reprogrammierbaren Schaltkreis und reprogrammierbarer Schaltkreis mit optimiertem Programmcode**

(30) Priorität: 04.06.1997 DE 19723457
(71) Anmelder: SIEMENS AKTIENGESELLSCHAFT, 80333 München (DE)
(72) Erfinder: Ecker, Wolfgang, Dr., 81377 München (DE)

(57) **Zusammenfassung**

Es wird ein Verfahren angegeben, das es ermöglicht, Signallaufzeiten in einem reprogrammierbaren Schaltkreis zu optimieren. Ein solcher reprogrammierbarer Schaltkreis umfaßt einzelne Zellen, die wiederum enthalten je einen kombinatorischen Block und ein Register. Nun kann bei einem reprogrammierbaren Schaltkreis eine Optimierung der Signallaufzeit nach der Programmierung des Schaltkreises erfolgen, indem einzelne Register umprogrammiert werden, d.h. benutzt geschaltete Register werden unbenutzt geschaltet (überbrückt) oder umgekehrt. Die Signallaufzeiten werden dadurch optimiert, daß die Anzahlen von komibatorischen Blöcken zwischen jeweils zwei Registern in etwa gleich gewählt werden.

## Beschreibung

Ein handelsüblicher reprogrammierbarer Schaltkreis wird mit einem Code (Bitstream), der die in dem Schaltkreis zu programmierende Schaltung bestimmt, programmiert. Damit kann in den reprogrammierbaren Schaltkreis eine nahezu beliebige vorgebbare Schaltung einprogrammiert werden.

Der reprogrammierbare Schaltkreis umfaßt eine Vielzahl von Zellen, wobei jede Zelle einen kombinatorischen Block und ein Register enthält. Die kombinatorischen Blöcke umfassen dabei einer vorgebbaren Schaltung entsprechende Verknüpfungen, die Register können wahlweise benutzt oder unbenutzt geschaltet sein, wobei die Register die Schaltung zu einer synchronen Schaltung (gleichbedeutend mit synchronem Schaltwerk), abhängig von einem Taktsignal, werden läßt.

Synchrone Schaltungen sind dem Fachmann bekannt als Schaltungen, die auf einem gemeinsamen Takt basieren und zu gleichen Zeitpunkten, sei es auf die positive Flanke oder die negative Flanke des Taktsignals, schalten. Eine Definition für ein synchrones Schaltwerk (= synchrone Schaltung) wird in H.-J.Schneider, Lexikon der Informatik und Datenverarbeitung, 2.Auflage, Oldenbourg Verlag, München 1986, ISBN 3-486-22662-2, S.508, 509, gegeben.

Bei der Entwicklung synchroner Schaltungen liegen zwischen Registern kombinatorische Blöcke. Die Signallaufzeit durch die kombinatorischen Blöcke, sowie Aufbauzeit (Setuptime) und Haltezeit (Holdtime) der Register bestimmen die maximale Taktfrequenz, mit der die synchrone Schaltung betrieben werden kann.

Die maximale Taktfrequenz eines reprogrammierbaren Schaltkreises reicht in der Praxis oftmals nicht aus. eine Steigerung der Leistungsfähigkeit wäre wünschenswert.

Die Aufgabe der Erfindung besteht darin, die Signallaufzeit in einem reprogrammierbaren Schaltkreis zu optimieren, wobei die Optimierung nach der Programmierung des reprogrammierbaren Schalkreises durchgeführt wird.

Diese Aufgabe wird gemäß den Merkmalen des Patentanspruchs 1 gelöst.

Zunächst wird der reprogrammierbare Schalkreis mit der vorgebbaren Schaltung programmiert. Dabei wird eine Reihe aus kombinatorischer Blöcke und Registern gebildet, wobei jedes Register wahlweise benutzt oder unbenutzt geschaltet ist. Nach der Programmierung findet die Optimierung der Signallaufzeiten statt, indem in der Reihe Anzahlen von kombinatorischen Blöcken zwischen je zwei benutzt geschalteten Registern in etwa gleich gewählt werden.

Weiterhin umfaßt die Erfindung einen reprogrammierbaren Schaltkreis, der eine in der Signallaufzeit optimierten Programmcode enthält, wobei in etwa gleiche Anzahlen kombinatorischer Blöcke zwischen benutzt geschalteten Registern angeordnet sind.

Es ist vorteilhaft, die Optimierung der Signallaufzeiten nach der Programmierung durchzuführen, da zu diesem Zeitpunkt die Signallaufzeiten exakt feststellbar sind und somit die Optimierung nicht auf einer bloßen Schätzung beruht.

Ausführungsbeispiele der Erfindung werden nachfolgend anhand der Zeichnungen dargestellt und erläutert.

Es zeigen
- Fig.1: eine Zelle des reprogrammierbaren Schaltkreises, die einen kombinatorischen Block und ein Register umfaßt,
- Fig.2: eine Reihe aus kombinatorischen Blöcken und Registern vor der Optimierung der Signallaufzeiten,
- Fig.3: eine Reihe aus kombinatorischen Blöcken und Registern nach der Optimierung der Signallaufzeiten.

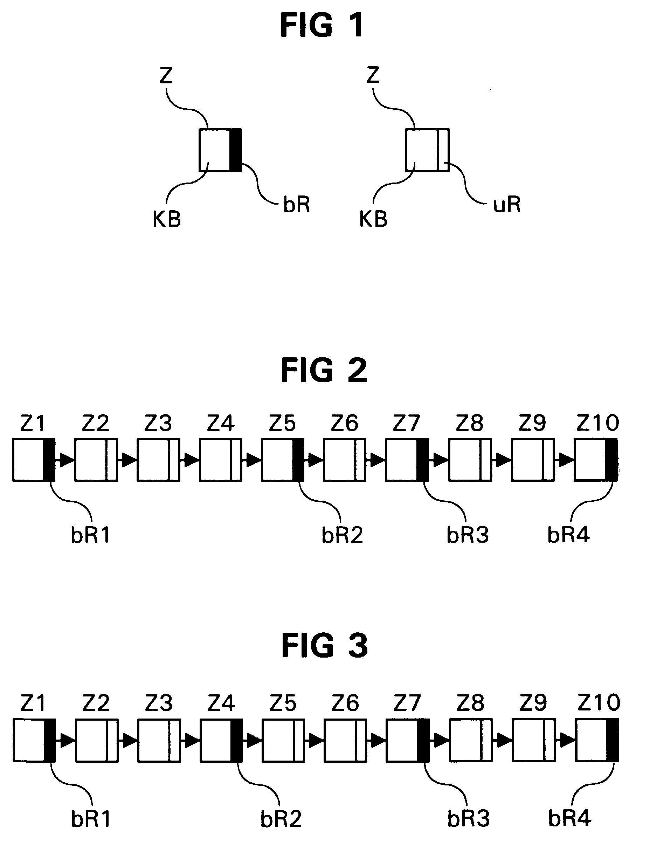

In Fig.1 sind zwei mögliche Zustände einer einzelnen Zelle Z dargestellt. Die Zelle besteht aus einem kombinatorischen Block KB und einem Register, das wahlweise benutzt geschaltet bR oder unbenutzt geschaltet uR sein kann.

In Fig.2 ist eine Reihe aus kombinatorischen Blöcken und Registern vor einer Optimierung der Signallaufzeit dargestellt. Bei reprogrammierbaren Schalkreisen besteht nun die Möglichkeit das Register einer Zelle wahlweise nach der Programmierung zu überbrücken und damit unbenutzt zu schalten oder es benutzt zu schalten. In Fig.2 ist eine mögliche benutzt-unbenutzt-Abfolge von Registern in Zellen Z1 bis Z10 nach der Programmierung des reprogrammierbaren Schaltkreises dargestellt. Nach dem ersten benutzten Register bR1 folgen 4 kombinatorische Blöcke bis zum nächsten benutzt geschalteten Register bR2, dann folgen 2 kombinatorische Blöcke bis zum benutzt geschalteten Register bR3 und schließlich noch einmal 3 kombinatorische Blöcke bis zum benutzt geschalteten Register bR4.

Fig.2 ist als Ausschnitt einer Reihe von Zellen aus einem reprogrammierbaren Schaltkreis zu sehen, wobei auch mehrere reprogrammierbare Schaltkreise miteinander verbunden sein können.

In Fig.3 wird gezeigt, wie die Optimierung der Signallaufzeit durchgeführt wird. Dazu werden, ausgehend von Fig.2, einzelne Register umprogrammiert, d.h. von benutzt zu unbenutzt und umgekehrt geschaltet. Hier wird davon ausgegangen, daß die Anzahlen von kombinatorischen Blöcken zwischen den Registern gleich sind, wobei im Sinne der Erfindung diese auch in etwa gleich sein können, bezogen auf die jeweilige Anwendung. Somit sind in Fig.3 jeweils zwischen den benutzt geschalteten Registern bR1 und bR2, bR2 und bR3, bR3 und bR4 drei kombinatorische Blöcke dargestellt, wobei die Signallaufzeiten durch die kombinatorischen Blöcke zwischen den Registern in etwa gleich ist. Der reprogrammierbare Schaltkreis ist also im Hinblick auf die Signallaufzeit optimiert, die maximal zulässige Taktrate sichert die größtmögliche Leistungsfähigkeit des Bausteins.

Hat man einen für den reprogrammierbaren Schaltkreis optimierten Programmcode ermittelt, kann dieser für die ganze Serie reprogrammierbarer Schaltkreise mit diesem Programmcode verwendet werden.

## Patentansprüche

1. Verfahren zur Optimierung von Signallaufzeiten in einem reprogrammierbaren Schaltkreis, der einzelne Zellen aufweist, wobei jede Zelle einen kombinatorischen Block und ein Register enthält,
a) bei dem eine Programmierung des reprogrammierbaren Schaltkreises durchgeführt wird, wobei eine Reihe aus den kombinatorischen Blöcken und den Registern gebildet und jedes Register wahlweise benutzt oder unbenutzt geschaltet wird;
b) bei dem nach der Programmierung des reprogrammierbaren Schaltkreises die Optimierung von Signallaufzeiten dadurch durchgeführt wird, daß in der Reihe Anzahlen von kombinatorischen Blöcken zwischen je zwei benutzt geschalteten Registern in etwa gleich gewählt werden.

2. Reprogrammierbarer Schaltkreis, der einzelne Zellen aufweist, wobei jede Zelle einen kombinatorischen Block und ein Register enthält, mit einem in den Signallaufzeiten optimierten Programmcode,
bei dem in etwa gleiche Anzahlen kombinatorischer Blöcke zwischen benutzt geschalteten Registern angeordnet sind.
